Europäisches Patentamt

European Patent Office

Office européen des brevets

(19)

(11) EP 0 791 179 B1

(12) EUROPÄISCHE PATENTSCHRIFT

(45) Veröffentlichungstag und Bekanntmachung des Hinweises auf die Patenterteilung:
08.09.1999 Patentblatt 1999/36

(21) Anmeldenummer: 95937770.6

(22) Anmeldetag: 06.11.1995

(51) Int Cl.6: G01R 31/08

(86) Internationale Anmeldenummer:
PCT/DE95/01594

(87) Internationale Veröffentlichungsnummer:
WO 96/14585 (17.05.1996 Gazette 1996/22)

(54) **VERFAHREN ZUM FESTSTELLEN DES ORTES EINES FEHLERS IN EINEM VORGEGEBEN ÜBERWACHSUNGSBEREICH EINES MEHRPHASIGEN ELEKTRISCHEN ENERGIEÜBERTRAGUNGSLEITUNGSSYSTEMS**

METHOD OF LOCATING A FAULT IN A PREDETERMINED MONITORING REGION OF A MULTIPHASE ELECTRICAL POWER TRANSMISSION SYSTEM

PROCEDE POUR DETECTER L'EMPLACEMENT D'UN DEFAUT DANS UNE ZONE DE SURVEILLANCE PREDETERMINEE D'UN SYSTEME DE TRANSMISSION D'ENERGIE ELECTRIQUE POLYPHASE

(84) Benannte Vertragsstaaten:
FR GB

(30) Priorität: 08.11.1994 DE 4441334

(43) Veröffentlichungstag der Anmeldung:
27.08.1997 Patentblatt 1997/35

(73) Patentinhaber: SIEMENS AKTIENGESELLSCHAFT
80333 München (DE)

(72) Erfinder:
• PHILIPPOT, Luc
71229 Leonberg (DE)
• CHEN, Zhihong
B-1050 Brüssel (BE)

(56) Entgegenhaltungen:
EP-A- 0 053 069          EP-A- 0 106 790
DE-B- 2 615 556

• SOVIET INVENTIONS ILLUSTRATED, EI Sektion, Woche 8737, ver!ffentlicht 28 Oktober 1987, DERWENT PUBLICATIONS LTD., London; & SU,A,1287 057.

**Beschreibung**

Es ist allgemein bekannt, einen vorgegebenen Bereich eines elektrischen Energieübertragungsleitungssystems, beispielsweise einen Abschnitt einer dreiphasigen Energieübertragungsleitung, auf einen Fehler dadurch zu überwachen, daß an jedem Ende des Abschnittes der elektrischen Energieübertragungsleitung eine Schutzeinrichtung angeordnet ist. Jeder Schutzeinrichtung ist im allgemeinen eine Anregeschaltung zugeordnet, die beim Auftreten eines Fehlers ein Signal zur Aktivierung der zugeordneten Schutzeinrichtung abgibt.

Es ist ferner bekannt, ("New accurate transmission line fault location equipment", IEE Conf. Publ. 302, 1989, Seiten 1 bis 5) an beiden Enden eines zu überwachenden Abschnitts einer mehrphasigen elektrischen Energieübertragungsleitung im Rahmen eines Verfahrens zur Fehlerortung Ströme und Spannungen zu speichern, und zwar in der Weise, daß Werte unmittelbar vor und während eines aufgetretenen Fehlers festgehalten werden. Die gespeicherten Werte werden abgetastet und in unterschiedlicher Weise in Abhängigkeit davon weiterverarbeitet, ob sie gespeicherten Werten vor oder während eines Fehlers zuzuordnen sind.

Wie ergänzend aus "IEE Proceedings", Vol. 137, Pt.C, Nr. 6, November 1990, Seiten 395 bis 402 hervorgeht, wird bei diesem bekannten Verfahren bei einer dreiphasigen Energieübertragungsleitung zur genauen Ortung eines Fehlers eine Berücksichtigung von Größen vorgenommen, die sich bei Anwendung der bekannten Clarke-Transformation beim Übergang zu modalen Größen bzw. Funktionen ergeben. Dabei werden an jedem Ende eines zu überwachenden Abschnitts einer elektrischen Energieübertragungsleitung zunächst die Abtastwerte berücksichtigt, die aus jeweils unmittelbar vor dem Auftreten eines Fehlers gespeicherten Strömen und Spannungen gewonnen sind, und es werden aus diesen Abtastwerten Vorfehler-Zeiger-Meßgrößen eines aerialen Modus gebildet. Dabei handelt es sich bei dem aerialen Modus um einen Modus, der neben einem weiteren aerialen Modus und einem sogenannten erdbezogenen Modus der Transformation nach Clarke eigen ist. Mittels der Vorfehler-Zeiger-Meßgrößen wird ein Phasenwinkel ermittelt, der sich aufgrund der asynchronen Abtastung an den beiden Enden des zu überwachenden Abschnitts der Energieübertragungsleitung zwischen den Vorfehler-Zeiger-Meßgrößen ergibt. Unter Benutzung der Vorfehler-Zeiger-Meßgrößen werden bei dem bekannten Verfahren mit Berücksichtigung von Abtastwerten, die aus während des Fehlers gespeicherten Strömen und Spannungen gebildet sind, über Zwischengewinnung von Differenz-Zeiger-Meßgrößen Fehler-Zeiger-Spannungsgrößen errechnet, womit Meßgrößen gemeint sind, die von beiden Enden des zu überwachenden Abschnittes der elektrischen Energieübertragungsleitung her betrachtet die Spannung an der Fehlerstelle bezeichnen. Da die von beiden Seiten her für dieselbe Fehlerstelle ermittelten Fehler-Zeiger-Spannungsgrößen gleich sein müssen, ergibt sich daraus die Möglichkeit, den Ort des Fehlers relativ genau auszurechnen. Voraussetzung dafür allerdings ist, daß die beiden Fehler-Zeiger-Spannungsgrößen in ihrer Phase miteinander übereinstimmen. Da dies bei dem bekannten Verfahren nicht der Fall ist, wird der Phasenwinkel mit den Vorfehler-Zeiger-Meßgrößen ermittelt und eine entsprechende Phasenwinkel-Meßgröße gebildet. Mit dieser Meßgröße wird eine Synchronisierung der Fehler-Zeiger-Spannungsgrößen vorgenommen und erst dann aus den Fehler-Zeiger-Spannungsgrößen der Ort des Fehlers ermittelt.

Das bekannte Verfahren ist insofern mit einer gewissen Unsicherheit bei der Feststellung des Ortes eines Fehlers behaftet, als bei der Clarke-Transformation eine vollkommene Diagonalisierung nicht möglich ist. Hier setzt die Erfindung an, indem sie sich die Aufgabe stellt, ein Verfahren zum Feststellen des Ortes eines Fehlers in einem vorgegebenen Bereich eines mehrphasigen elektrischen Energieübertragungsleitungssystems vorzuschlagen, das sich durch eine besonders hohe Meßgenauigkeit auszeichnet.

Die Lösung dieser Aufgabe wird erfindungsgemäß dadurch erreicht, daß Verfahren zum Feststellen des Ortes eines Fehlers in einem vorgegebenen Überwachungsbereich eines mehrphasigen elektrischen Energieübertragungsleitungssystems unter Erfassen von Strömen und Spannungen der Phasenleiter an den beiden Enden des Überwachungsbereiches, bei dem unmittelbar vor und während des Fehlers an den beiden Enden des Überwachungsbereichs den jeweiligen Strömen und Spannungen proportionale Meßgrößen unter Bildung von Abtastwerten gemessen und gespeichert werden, aus den unmittelbar vor dem Auftreten des Fehlers gebildeten Abtastwerten gemäß der Clarke-Transformation Vorfehler-Zeiger-Meßgrößen eines aerialen Modus $\alpha$ und eines weiteren aerialen Modus $\beta$ für beide Enden des Überwachungsbereiches gebildet werden, die Vorfehler-Zeiger-Meßgrößen der beiden Enden des Überwachungsbereichs auf ihre Phasenlage zueinander untersucht werden und eine dem Phasenwinkel entsprechende Phasenwinkel-Meßgröße gebildet wird, indem aus den Vorfehler-Zeiger-Meßgrößen der beiden Enden des Überwachungsbereiches für beide aeriale Moden Spannungen und Ströme gebildet werden, die auf der der halben Länge des Überwachungsbereiches auftreten, die beiden Spannungen und die beiden Ströme des jeweiligen aerialen Modus $\alpha$, $\beta$ jeweils voneinander subtrahiert werden und die so gebildeten Abweichungsgrößen quadriert werden und aus einem durch Schätzung gewonnenen Minimalwert der Summe der quadrierten Abweichungsgrößen die Phasenwinkel-Meßgrößen bestimmt wird, unter Berücksichtigung der Phasenwinkel-Meßgröße aus den beim Auftreten des Fehlers gewonnenen Abtastwerten unter Berücksichtigung der Vorfehler-Zeiger-Meßgrößen für beide aerialen Moden und jedes der beiden Enden des Überwachungsbereiches synchronisierte spannungs- und strombezogene Differenz-Zeiger-Meßgrößen gebildet werden, aus den synchronisierten Differenz-Zeiger-Meßgrößen für beide aerialen Moden und für jedes der beiden Enden des Überwachungsbereichs je eine Fehler-Zeiger-Spannungsgröße gebildet wird, die Fehler-Zeiger-Spannungsgrößen des jeweiligen aerialen Modus voneinander subtrahiert und die so gebildeten Differenzgrößen quadriert werden und aus einem durch Schätzung gewonnenen Minimalwert der Summe der quadrierten Differenzgrößen der Ort des Fehlers bestimmt wird.

Der wesentliche Vorteil des erfindungsgemäßen Verfahrens besteht darin, daß bei ihm durch Benutzung der weiteren Vorfehler-Zeiger-Meßgrößen eines weiteren aerialen Modus und der weiteren Fehler-Zeiger-Spannungsgrößen desselben weiteren aerialen Modus die Möglichkeit gegeben ist, den Ort des Fehlers mittels einer Schätzung nach dem Kriterium der kleinsten Quadrate durchzuführen, wodurch der Fehlerort mit vergleichsweise hoher Genauigkeit bestimmbar ist.

Bei dem erfindungsgemäßen Verfahren kommt dem Gewinnen einer genauen Phasenwinkelmeßgröße eine besondere Bedeutung zu, weil die Meßgenauigkeit des erfindungsgemäßen Verfahrens auch von der genauen Feststellung der Phasenwinkel-Meßgröße abhängt. Dem trägt das erfindungsgemäße Verfahren ebenfalls Rechnung, da nicht nur unter Benutzung von Vorfehler-Zeiger-Spannungsgrößen sondern auch unter Heranziehung von Vorfehler-Zeiger-Stromgrößen Abweichungsgrößen gebildet werden, die nach Quadrierung ebenfalls einer Schätzung nach dem Kriterium der kleinsten Quadrate unterworfen werden, wodurch die Phasenwinkel-Meßgröße mit großer Genauigkeit ermittelbar ist.

Zur weiteren Erläuterung der Erfindung sind in

Figur 1   eine dreiphasige Energieübertragungsleitung mit einem zu überwachenden Abschnitt, in
Figur 2   eine Art Blockschaltbild zur näheren Erläuterung des Ablaufs des erfindungsgemäßen Verfahrens, in
Figur 3   ein Zeigerdiagramn zur Erläuterung der Bestimmung der Phasenwinkel-Meßgröße bei Spannungsbetrachtungen, in
Figur 4   ein der Fig. 3 entsprechendes Zeigerdiagramm bei Strombetrachtungen und in
Figur 5   der zu überwachende Bereich einer Energieübertragungsleitung mit einem Fehler dargestellt.

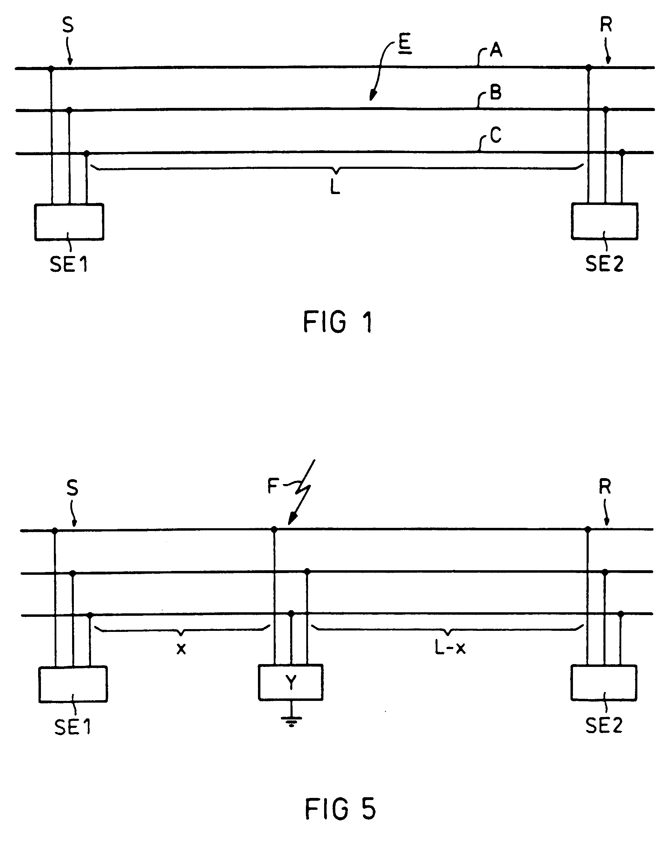

Gemäß Figur 1 weist eine elektrische Energieübertragungsleitung E drei Phasenleiter A, B und C auf. Die elektrische Energieübertragungsleitung E erstreckt sich zwischen einem Ende S und einem weiteren Ende R. Sie hat eine Länge L. An den Enden S und R der elektrischen Energieübertragungsleitung E ist jeweils eine Schutzeinrichtung SE1 bzw. SE2 angeordnet, die in nur schematisch dargestellter Weise mit den Strömen in den Phasenleitern A bis C und den Spannungen an diesen Phasenleitern beaufschlagt sind.

Jede der Schutzeinrichtungen SE1 bzw. SE2 enthält beispielsweise eine nicht dargestellte Distanzschutzeinrichtung mit einer ebenfalls nicht gezeigten Anregeschaltung. Ferner ist jede Schutzeinrichtung SE1 bzw. SE2 mit einer in Fig. 1 nicht gezeigten Einrichtung zur Aufzeichnung der Ströme in den Phasenleitern A, B und C bzw. der Spannungen an diesen Phasenleitern der elektrischen Energieübertragungsleitung E ausgerüstet.

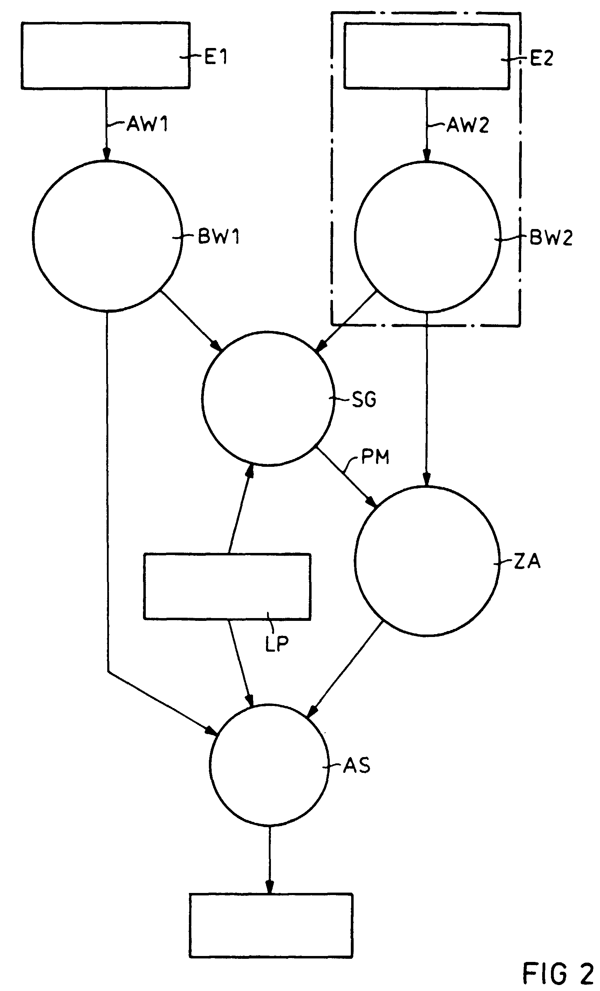

Wie Figur 2 zeigt, ist jeder dieser - nur schematisch dargestellten - Einrichtungen E1 bzw. E2 zur Aufzeichnung der Ströme und Spannungen eine Bewertungsschaltung BW1 bzw. BW2 nachgeordnet, denen nach einem aufgetretenen Fehler Abtastwerte AW1 bzw. AW2 zugeführt werden. Die Abtastwerte AW1 und AW2 sind durch Abtastung der von den Einrichtungen E1 und E2 unmittelbar vor und während eines Fehlers aufgezeichneten Verläufe der Ströme und Spannungen in den Leitern A bis C der elektrischen Energieübertragungsleitung E gebildet. Unter Berücksichtigung der bekannten Clarke-Transformation werden in den Bewertungsschaltungen BW1 und BW2 aus unmittelbar vor dem Auftreten eines Fehlers aufgezeichneten Strömen und Spannungen gewonnenen Abtastwerten Vorfehler-Zeiger-Meßgrößen $\underline{V}^S_{BF,m}$ und $\underline{I}^S_{BF,m}$ bzw. $\underline{V}^{R,async}_{BF,m}$ und $\underline{I}^{R,async}_{BF,m}$ als spannungs- bzw. strombezogene Vorfehler-Zeiger-Meßgrößen gebildet. Dabei ist mit "m" der eine (α-) bzw. der weitere (β)-aeriale Modus gemäß der Clarke-Transformation gemeint. Mit den Buchstaben "S" und "R" sind die entsprechenden Enden der Energieübertragungsleitung gekennzeichnet, während "async" ausdrückt, daß die dem Ende R zugeordneten Vorfehler-Zeiger-Meßgrößen nicht mit denen des Endes S synchronisiert sind.

Die so gebildeten Vorfehler-Zeiger-Meßgrößen $\underline{V}^S_{BF,m}$ und $\underline{I}^S_{BF,m}$ bzw. $\underline{V}^{R,async}_{BF,m}$ und $\underline{I}^{R,async}_{BF,m}$ werden einer Schätzeinrichtung SG zugeführt, in der die Ermittlung einer Phasenwinkel-Meßgröße PM erfolgt. In dieser Schätzeinrichtung SG werden zu diesem Zwecke mit den Vorfehler-Zeiger-Meßgrößen von den beiden Enden S und R bzw. von den Schutzeinrichtungen SE1 und SE2 "kommende" Ströme $\underline{I}^S_m$ und $\underline{I}^R_m$ sowie Spannungen $\underline{V}^S_m$ und $\underline{V}^R_m$ ausgerechnet, die auf der halben Länge L/2 des zu überwachenden Leitungsabschnittes auftreten. Diese Größen lassen sich jeweils durch folgende Formeln beschreiben:

$$\underline{V}^S_m = \cosh\left(\underline{\gamma}_m \cdot \frac{L}{2}\right) \cdot \underline{V}^S_{BF,m} - \underline{Zc}_m \cdot \sinh\left(\underline{\gamma}_m \cdot \frac{L}{2}\right) \cdot \underline{I}^S_{BF,m} \quad (1)$$

$$V_m^R = \cosh\left(\underline{\gamma}_m \cdot \frac{L}{2}\right) \cdot \underline{V}_{BF,m}^{R,async} \cdot e^{j \cdot \delta}$$

$$+ \underline{Zc}_m \cdot \sinh\left(\underline{\gamma}_m \cdot \frac{L}{2}\right) \cdot \underline{I}_{BF,m}^{R,async} \cdot e^{j \cdot \delta} \qquad (2)$$

$$I_m^S = \underline{Zc}_m \cdot \cosh\left(\underline{\gamma}_m \cdot \frac{L}{2}\right) \cdot \underline{I}_{BF,m}^S - \sinh\left(\underline{\gamma}_m \cdot \frac{L}{2}\right) \cdot \underline{V}_{BF,m}^S \qquad (3)$$

$$I_m^R = \underline{Zc}_m \cdot \cosh\left(\underline{\gamma}_m \cdot \frac{L}{2}\right) \cdot \underline{I}_{BF,m}^{R,async} \cdot e^{j \cdot \delta}$$

$$- \sinh\left(\underline{\gamma}_m \cdot \frac{L}{2}\right) \cdot \underline{V}_{BF,m}^{R,async} \cdot e^{j \cdot \delta} \qquad (4)$$

Da die Ströme und Spannungen in der angenommenen Mitte des zu überwachenden Bereichs der Energieübertragungsleitung E gleich groß sein müssen, läßt sich bezüglich der Spannungen folgende Beziehung (5) aufstellen:

$$\underline{\varepsilon}_{Vm} = \cosh\left(\underline{\gamma}_m \cdot \frac{L}{2}\right) \cdot \underline{V}_{BF,m}^S - \underline{Zc}_m \cdot \sinh\left(\underline{\gamma}_m \cdot \frac{L}{2}\right) \cdot \underline{I}_{BF,m}^S$$

$$- \cosh\left(\underline{\gamma}_m \cdot \frac{L}{2}\right) \cdot \underline{V}_{BF,m}^{R,async} \cdot e^{j \cdot \delta}$$

$$+ \underline{Zc}_m \cdot \sinh\left(\underline{\gamma}_m \cdot \frac{L}{2}\right) \cdot \underline{I}_{BF,m}^{R,async} \cdot e^{j \cdot \delta} \qquad 5)$$

Eine entsprechende Beziehung läßt sich für die Ströme ermitteln, wie die nachstehende Gleichung (6) zeigt:

$$\underline{\varepsilon}_{Im} = \underline{Zc}_m \cdot \cosh\left(\underline{\gamma}_m \cdot \frac{L}{2}\right) \cdot \underline{I}_{BF,m}^S - \sinh\left(\underline{\gamma}_m \cdot \frac{L}{2}\right) \cdot \underline{V}_{BF,m}^S$$

$$+ \underline{Zc}_m \cdot \cosh\left(\underline{\gamma}_m \cdot \frac{L}{2}\right) \cdot \underline{I}_{BF,m}^{R,async} \cdot e^{j \cdot \delta}$$

$$- \sinh\left(\underline{\gamma}_m \cdot \frac{L}{2}\right) \cdot \underline{V}_{BF,m}^{R,async} \cdot e^{j \cdot \delta} \qquad (6)$$

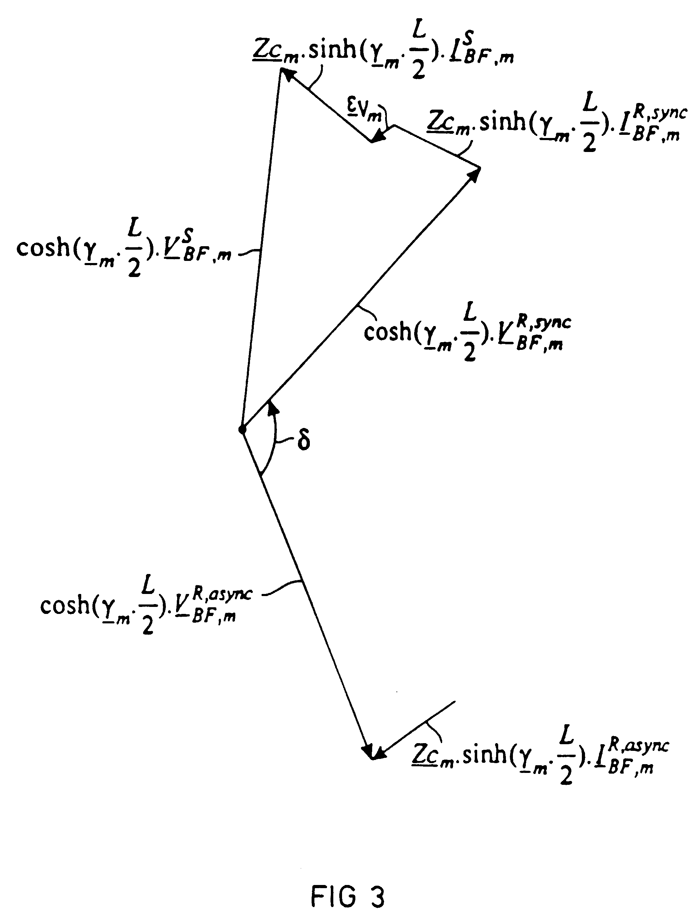

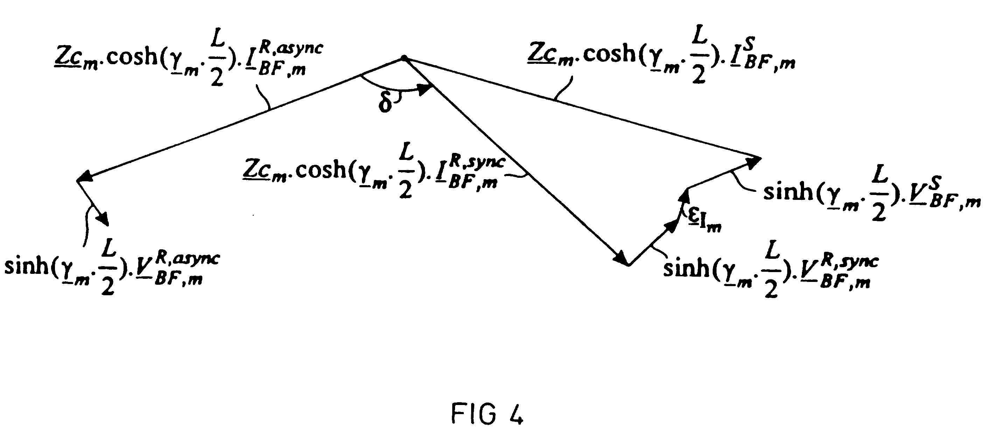

In den Gleichungen (1) bis (6) ist mit $\underline{Zc}_m$ jeweils die modale Leitungsimpedanz und mit $\gamma_m$ die modale Ausbreitungskonstante nach der Clarke-Transformation bezeichnet. Mit $\delta$ ist der Phasenwinkel zwischen den jeweils einander zugeordneten Vorfehler-Zeiger-Meßgrößen bezeichnet. Die Größen $\underline{\varepsilon}_{Vm}$ und $\underline{\varepsilon}_{Im}$ bezeichnen Fehlergrößen. In Figur 3 sind die einzelnen Größen für die Spannungsverhältnisse und in Figur 4 für die Stromverhältnisse figürlich dargestellt.

Zur Ermittlung des Phasenwinkels $\delta$ bzw. der Phasenwinkel-Meßgröße $PM$ werden die Quadrate der Differenzgrößen $\underline{\varepsilon}_{Vm}$ und $\underline{\varepsilon}_{Im}$ für beide aerialen Moden $\alpha$ und $\beta$ gebildet unter Bildung einer eindimensionalen Kostenfunktion $K_f$ gemäß der folgenden Gleichung (7):

$$K_f = | \underline{\varepsilon}_{v_\alpha} |^2 + | \underline{\varepsilon}_{v_\beta} |^2 + | \underline{\varepsilon}_{I_\alpha} |^2 + | \underline{\varepsilon}_{I_\beta} |^2 \tag{7}$$

Nach dem Kriterium der kleinsten Quadrate wird unter Benutzung der Simplexmethode die Kostenfunktion $K_f$ minimiert, woraus sich der Phasenwinkel $\delta$ bzw. die Phasenwinkel-Meßgröße *PM* ergibt. Vom Block LP werden dabei die Leitungsparameter zur Verfügung gestellt.

In den Bewertungseinrichtungen BW1 und BW2 werden außer den Vorfehler-Zeiger-Meßgrößen Differenz-Zeiger-Meßgrößen $\underline{V}_{SUP,m}^S$ und $\underline{V}_{SUP,m}^{R,async}$ sowie $\underline{I}_{SUP,m}^S$ und $\underline{I}_{SUP,m}^{R,async}$ gemäß dem einen und dem weiteren aerialen Modus $\alpha$ und $\beta$ dadurch gebildet, daß jeweils eine Differenz zwischen jeweils einer Zeiger-Meßgröße erzeugt wird, die aus während des Fehlers gespeicherten Strömen und Spannungen gebildeten Abtastwerten jeweils hergeleitet wird (in beiden aerialen Moden), und der zugehörigen Vorfehler-Zeiger-Meßgröße gebildet wird. Dabei werden die mittels der Bewertungsschaltung BW2 aus den Werten am Leitungsende R gebildeten Differenz-Zeiger-Meßgrößen in einer Zwischenanordnung ZA in ihrer Phase entsprechend dem ermittelten Phasenwinkel $\delta$ gedreht; zu diesem Zwecke wird die Zwischenanordnung ZA mit der Phasenwinkel-Meßgröße PM beaufschlagt. Es entstehen am Ausgang der Zwischenanordnung die Meßgrößen $\underline{V}_{SUP,m}^R$ und $\underline{I}_{SUP,m}^R$.

Der der Zwischenschaltung ZA nachgeordneten Auswerteschaltung AS werden demzufolge mit Differenz-Zeiger-Meßgrößen $\underline{V}_{SUP,m}^S$ und $\underline{I}_{SUP,m}^S$ der Bewertungsschaltung BW1 synchronisierte Differenz-Zeiger-Meßgrößen $\underline{V}_{SUP,m}^R$ und $\underline{I}_{SUP,m}^R$ zugeführt; es werden dort mit diesen Differenz-Zeiger-Meßgrößen Fehler-Zeiger-Spannungsgrößen $\underline{V}_{SUP,m}^{F\,von\,S}$, $\underline{V}_{SUP,m}^{F\,von\,R}$ sowohl von dem einen Ende S als auch vom anderen Ende R entsprechend den Gleichungen (8) und (9) gebildet:

$$\underline{V}_{SUP,m}^{F\,from\,S} = \cosh\left(\underline{Y}_m \cdot x\right) \cdot \underline{V}_{SUP,m}^S - \underline{Zc}_m \cdot \sinh\left(\underline{Y}_m \cdot x\right) \cdot \underline{I}_{SUP,m}^S \tag{8}$$

$$\underline{V}_{SUP,m}^{F\,from\,R} = \cosh\left(\underline{Y}_m \cdot (L - x)\right) \cdot \underline{V}_{SUP,m}^R \\ - \underline{Zc}_m \cdot \sinh\left(\underline{Y}_m \cdot (L - x)\right) \cdot \underline{I}_{SUP,m}^R \tag{9}$$

Jeweils einander zugeordnete Fehler-Zeiger-Spannungsgrößen desselben aerialen Modus $\alpha$ bzw. $\beta$ werden voneinander subtrahiert unter Bildung von Abweichungsgrößen $\underline{\varepsilon}_{v_{m,SUP}}$ gemäß der nachstehenden Gleichung (10):

$$\underline{\varepsilon}_{v_{m,SUP}} = \underline{V}_{SUP,m}^{F\,from\,S} - \underline{V}_{SUP,m}^{F\,from\,R} \tag{10}$$

Aus den Quadraten der Abweichungsgrößen wird wiederum eine eindimensionale Kostenfunktion K entsprechend der nachstehenden Gleichung (11) gebildet, die nach dem Kriterium der kleinsten Fehler-Quadrate ausgewertet wird.

$$K(\chi) = | \underline{\varepsilon}_{v_{\alpha,SUP}} |^2 + | \underline{\varepsilon}_{v_{\beta,SUP}} |^2 \tag{11}$$

Daraus läßt sich mit großer Genauigkeit die Lage x eines Fehlers F auf der Übertragungsleitung E ermitteln, (vgl. Figur 5).

Die Gleichungen (8) und (9) beschreiben die Verhältnisse nur näherungsweise. Bei einer genauen Betrachtung unter partieller Kopplungskompensation ergibt sich z.B. für die Fehler-Zeiger-Spannungsgröße $\underline{V}_{SUP,m}^{F\,from\,S}$ gemäß nachstehender Gleichung (12):

$$\underline{V}^{F\;from\;S}_{SUP,m} = \cosh\left(\underline{\gamma}_m \cdot x\right) \cdot \underline{V}^S_{SUP,m} - \underline{Zc}_m \cdot \sinh\left(\underline{\gamma}_m \cdot x\right) \cdot \underline{I}^S_{SUP,m}$$
$$-j \cdot M_{m,0} \cdot \chi \cdot \underline{I}^{S,\;equ}_{SUP,0} - j \cdot M_{m,m'} \cdot \chi \cdot \underline{I}^{S,\;equ}_{SUP,m'}, \qquad (12)$$

In dieser Gleichung (12) gibt jeweils "m" einen aerialen Modus und "m'" den jeweils anderen aerialen Modus an; j . $M_{m,o}$ . x bezeichnet die Reaktanz zwischen Meß- und Fehlerstelle, während "equ" dafür steht, daß es sich um einen Strom handelt, der integriert ist von der Meß- bis zur Fehlerstelle.

Die so korrigierten Fehler-Zeiger-Spannungsgrößen werden entsprechend den Gleichungen (10) und (11) ausgewertet.

Eine weitere Steigerung bei der Genauigkeit der Ermittlung des Ortes des Fehlers laßt sich mit dem erfindungsgemäßen Verfahren dann erreichen, wenn zusätzlich eine Fehlerschätzung in bezug auf die Induktivitäten der Energieübertragungsleitung vorgenommen wird. In diesem Falle wird von vorgegebenen Induktivitätswerten pro Längeneinheit der Energieübertragungsleitung ausgegangen und berücksichtigt, daß die Kostenfunktion gemäß Gleichung (7) nunmehr nicht nur vom Phasenwinkel δ, sondern auch von den Induktivitatswerten $l_m$ mit m = α oder β nach der Clarke-Transformation der Energieübertragungsleitung abhängt. Auch in diesem Falle erfolgt eine Minimierung nach der Simplex-Methode, wobei mit der Lösung für den Phasenwinkel δ und mit den vorgegebenen Induktivitätswerten begonnen wird.

Ist $l_m$ bestimmt, dann lassen sich die Größen $\underline{Z}c_m$ und $\gamma_m$ gemäß den nachfolgenden Gleichungen (13) und (14) ermitteln:

$$\underline{Z}c_m = \sqrt{\frac{r_m + j.\omega.l_m}{j.\omega.c_m}} \qquad (13)$$

$$\gamma_m = \sqrt{(r_m + j.\omega.l_m).(j.\omega.c_m)} \qquad (14)$$

in den $r_m$ und $c_m$ resistive bzw. kapazitive Leitungsparameter pro Längeneinheit nach Clarke bezeichnen. Mit den so gewonnenen Größen $\underline{Z}c_m$ und γm wird in die Gleichungen (8) und (9) gegangen und mittels der Gleichungen (10) und (11) anschließend der Ort x des Fehlers F genau bestimmt.

**Patentansprüche**

1.  Verfahren zum Feststellen des Ortes eines Fehlers (F) in einem vorgegebenen Überwachungsbereich (S-R) eines mehrphasigen elektrischen Energieübertragungsleitungssystems (E) unter Erfassen von Strömen und Spannungen der Phasenleiter an den beiden Enden des Überwachungsbereiches, bei dem

    -   unmittelbar vor und während des Fehlers (F) an den beiden Enden (S,R) des Überwachungsbereichs den jeweiligen Strömen und Spannungen proportionale Meßgrößen unter Bildung von Abtastwerten gemessen und gespeichert werden,
    -   aus den unmittelbar vor dem Auftreten des Fehlers (F) gebildeten Abtastwerten gemäß der Clarke-Transformation Vorfehler-Zeiger-Meßgrößen ($\underline{V}^S_{BF,m}, \underline{I}^S_{BF,m}, \underline{V}^{R,async}_{BF,m}, \underline{I}^{R,async}_{BF,m}$) eines aerialen Modus und eines weiteren aerialen Modus für beide Enden des Überwachungsbereiches gebildet werden,
    -   die Vorfehler-Zeiger-Meßgrößen ($\underline{V}^S_{BF,m}, \underline{I}^S_{BF,m}, \underline{V}^{R,async}_{BF,m}, \underline{I}^{R,async}_{BF,m}$) der beiden Enden (R,S) des Überwachungsbereichs auf ihre Phasenlage zueinander untersucht werden und eine dem Phasenwinkel (δ) entsprechende Phasenwinkel-Meßgröße gebildet wird, indem

        -   aus den Vorfehler-Zeiger-Meßgrößen ($\underline{V}^S_{BF,m}, \underline{I}^S_{BF,m}, \underline{V}^{R,async}_{BF,m}, \underline{I}^{R,async}_{BF,m}$) der beiden Enden des Überwachungsbereiches für beide aeriale Moden Spannungen und Ströme gebildet werden, die auf der halben Länge des Überwachungsbereiches auftreten,
        -   die beiden Spannungen und die beiden Ströme des jeweiligen aerialen Modus jeweils voneinander subtrahiert werden und die so gebildeten Abweichungsgrößen ($\varepsilon_{v_\alpha}, \varepsilon_{v_\beta}, \varepsilon_{I_\alpha}, \varepsilon_{I_\beta}$) quadriert werden und
        -   aus einem durch Schätzung gewonnenen Minimalwert der Summe der quadrierten Abweichungsgrößen die Phasenwinkel-Meßgröße bestimmt wird,
        -   aus den beim Auftreten des Fehlers gewonnenen Abtastwerten unter Berücksichtigung der Phasenwinkel-Meßgröße und der Vorfehler-Zeiger-Meßgrößen ($\underline{V}_{BF,m}^{S}$, $\underline{I}_{BF,m}^{S}$, $\underline{V}_{BF,m}^{R,async}$, $\underline{I}_{BF,m}^{R,async}$) für beide aerialen Moden und jedes der beiden Enden (S,R) des Überwachungsbereiches synchronisierte spannungs- und strombezogene Differenz-Zeiger-Meßgrößen gebildet werden,

- aus den synchronisierten Differenz-Zeiger-Meßgrößen für beide aerialen Moden und für jedes der beiden Enden des Überwachungsbereichs je eine Fehler-Zeiger-Spannungsgröße gebildet wird,
- die Fehler-Zeiger-Spannungsgrößen des jeweiligen aerialen Modus voneinander subtrahiert und die so gebildeten Differenzgrößen quadriert werden und
- aus einem durch Schätzung gewonnenen Minimalwert der Summe der quadrierten Differenzgrößen der Ort des Fehlers (F) bestimmt wird.

2.  Verfahren nach Anspruch 1,
    **dadurch gekennzeichnet**, daß

    - nach dem Gewinnen der Phasenwinkel-Meßgröße mittels weiterer Schätzung unter Berücksichtigung vorgegebener Induktivitätswerte des Energieübertragungssystems (E) Induktivitäts-Meßgrößen beider aerialen Moden gebildet werden und
    - die Induktivitats-Meßgrößen bei der Bildung der Fehler-Zeiger-Spannungsgrößen berücksichtigt werden.

## Claims

1.  Method for ascertaining the location of a fault (F) in a predetermined monitoring region (S-R) of a multi-phase electrical power transmission line system (E) with detection of currents and voltages of the phase conductors at both ends of the monitoring region, in which method,

    - immediately before and during the fault (F), measured variables which are proportional to the respective currents and voltages are measured and stored at both ends (S, R) of the monitoring region, forming sampled values,
    - from the sampled values formed immediately before the occurrence of the fault (F), in accordance with the Clarke transformation, pre-fault vector measured variables ($\underline{V}_{BF,m}^{S}$, $\underline{I}_{BF,m}^{S}$, $\underline{V}_{BF,m}^{R,async}$, $\underline{I}_{BF,m}^{R,async}$) of one aerial mode and of a further aerial mode are formed for both ends of the monitoring region,
    - the pre-fault vector measured variables ($\underline{V}_{BF,m}^{S}$, $\underline{I}_{BF,m}^{S}$, $\underline{V}_{BF,m}^{R,async}$, $\underline{I}_{BF,m}^{R,async}$) of both ends (R, S) of the monitoring region are examined for their phase angle with respect to each other and a phase-angle measured variable which corresponds to the phase angle ($\delta$) is formed by

        - forming from the pre-fault vector measured variables ($\underline{V}_{BF,m}^{S}$, $\underline{I}_{BF,m}^{S}$, $\underline{V}_{BF,m}^{R,async}$, $\underline{I}_{BF,m}^{R,async}$) of both ends of the monitoring region, for both aerial modes, voltages and currents which occur on half the length of the monitoring region,
        - subtracting both voltages and both currents of the respective aerial mode from each other and squaring the deviation variables ($\varepsilon_{V_\alpha}$, $\varepsilon_{V_\beta}$, $\varepsilon_{I_\alpha}$, $\varepsilon_{I_\beta}$) formed in this way,
        - and determining the phase-angle measured variable from a minimum value, obtained by estimation, of the sum of the squared deviation variables,

    - from the sampled values obtained during the occurrence of the fault, taking into account the phase-angle measured variable and the pre-fault vector measured variables ($\underline{V}_{BF,m}^{S}$, $\underline{I}_{BF,m}^{S}$, $\underline{V}_{BF,m}^{R,async}$, $\underline{I}_{BF,m}^{R,async}$) for both aerial modes and each of the two ends (S, R) of the monitoring region, synchronised voltage-related and current-related differential vector measured variables are formed,
    - from the synchronised differential vector measured variables for both aerial modes and for each of the two ends of the monitoring region, a respective fault vector voltage variable is formed,
    - the fault vector voltage variables of the respective aerial mode are subtracted from each other and the differential variables formed in this way are squared and
    - from a minimum value, obtained by estimation, of the sum of the squared differential variables, the location of the fault is determined.

2.  Method according to claim 1, characterised in that

    - after the generation of the phase-angle measured variable, by means of further estimation taking into account predetermined inductance values of the power transmission system (E), inductance measured variables of

7

both aerial modes are formed and
- the inductance measured variables are taken into account when forming the fault vector voltage variables.

**Revendications**

1. Procédé pour déterminer l'emplacement d'un défaut (F) dans une zone surveillée prédéterminée (S à R) d'un système de ligne de transmission d'énergie électrique polyphasée (E) au moyen d'une détection de courants et de tensions des conducteurs de phases aux deux extrémités de la zone surveillée, dans lequel

- on mesure et mémorise juste avant et pendant le défaut (F) aux deux extrémités (S, R) de la zone surveillée des grandeurs mesurées proportionnelles aux courants et tensions respectifs en formant des valeurs échantillonnées,
- on forme à partir des valeurs échantillonnées formées juste avant l'apparition du défaut (F) selon la transformation de Clarke des grandeurs mesurées vectorielles avant-défaut ( $\underline{V}_{BF,m}^{S}$ , $\underline{I}_{BF,m}^{S}$ , $\underline{V}_{BF,m}^{R,async}$ , $\underline{I}_{BF,m}^{R,async}$ ) d'un mode aérien et d'un autre mode aérien pour les deux extrémités de la zone surveillée,
- on examine les grandeurs mesurées vectorielles avant-défaut ( $\underline{V}_{BF,m}^{S}$ , $\underline{I}_{BF,m}^{S}$ , $\underline{V}_{BF,m}^{R,async}$ , $\underline{I}_{BF,m}^{R,async}$ ) des deux extrémités (R, S) de la zone surveillée quant à leur relation de phase l'une par rapport à l'autre et on forme une grandeur mesurée d'angle de phase correspondant à l'angle de phase ($\delta$)

  - en formant à partir des grandeurs mesurées vectorielles avant-défaut ( $\underline{V}_{BF,m}^{S}$ , $\underline{I}_{BF,m}^{S}$ , $\underline{V}_{BF,m}^{R,async}$ , $\underline{I}_{BF,m}^{R,async}$ ) des deux extrémités de la zone surveillée pour les deux modes aériens des tensions et des courants qui apparaissent sur la moitié de la longueur de la zone surveillée,
  - en soustrayant à chaque fois l'un de l'autre les deux tensions et les deux courants du mode aérien respectif et en élevant au carré les grandeurs d'écarts ($\underline{\varepsilon}\,V_{\alpha}$, $\underline{\varepsilon}\,V_{\beta}$, $\underline{\varepsilon}\,I_{\alpha}$, $\underline{\varepsilon}\,I_{\beta}$) ainsi formées et
  - en déterminant à partir d'une valeur minimale, obtenue par estimation, de la somme des carrés des grandeurs d'écarts la grandeur mesurée d'angle de phase,

- à partir des valeurs échantillonnées obtenues lors de l'apparition du défaut et en tenant compte de la grandeur mesurée d'angle de phase et des grandeurs mesurées vectorielles avant-défaut ($\underline{V}_{BF,m}^{S}$ , $\underline{I}_{BF,m}^{S}$ , $\underline{V}_{BF,m}^{R,async}$ , $\underline{I}_{BF,m}^{R,async}$), on forme pour les deux modes aériens et pour chacune des deux extrémités (S, R) de la zone surveillée des grandeurs mesurées vectorielles de différences synchronisées se rapportant à la tension et au courant,
- à partir des grandeurs mesurées vectorielles de différences synchronisées pour les deux modes aériens et pour chacune des deux extrémités de la zone surveillée, on forme à chaque fois une grandeur de tension vectorielle de défaut,
- on soustrait l'une de l'autre les grandeurs de tensions vectorielles de défaut du mode aérien respectif et on élève au carré les grandeurs de différences ainsi formées et
- on détermine à partir d'une valeur minimale, obtenue par estimation, de la somme des carrés des grandeurs de différences l'emplacement du défaut (F).

2. Procédé selon la revendication 1,
caractérisé par le fait que

- après l'obtention de la grandeur mesurée d'angle de phase, on forme au moyen d'une nouvelle estimation et en tenant compte de valeurs d'inductances prédéterminées du système de transmission d'énergie (E) des grandeurs mesurées d'inductances des deux modes aériens et
- on tient compte des grandeurs mesurées d'inductances lors de la formation des grandeurs de tensions vectorielles de défaut.

FIG 1

FIG 5

FIG 2

$$\underline{Zc}_m \cdot \sinh(\underline{\gamma}_m \cdot \frac{L}{2}) \cdot \underline{I}_{BF,m}^{S}$$

$$\underline{\varepsilon V}_m$$

$$\underline{Zc}_m \cdot \sinh(\underline{\gamma}_m \cdot \frac{L}{2}) \cdot \underline{I}_{BF,m}^{R,sync}$$

$$\cosh(\underline{\gamma}_m \cdot \frac{L}{2}) \cdot \underline{V}_{BF,m}^{S}$$

$$\cosh(\underline{\gamma}_m \cdot \frac{L}{2}) \cdot \underline{V}_{BF,m}^{R,sync}$$

$$\delta$$

$$\cosh(\underline{\gamma}_m \cdot \frac{L}{2}) \cdot \underline{V}_{BF,m}^{R,async}$$

$$\underline{Zc}_m \cdot \sinh(\underline{\gamma}_m \cdot \frac{L}{2}) \cdot \underline{I}_{BF,m}^{R,async}$$

## FIG 3

EP 0 791 179 B1

$$\underline{Zc}_m \cdot \cosh(\underline{\gamma}_m \cdot \frac{L}{2}) \cdot \underline{I}^{R,async}_{BF,m}$$

$$\underline{Zc}_m \cdot \cosh(\underline{\gamma}_m \cdot \frac{L}{2}) \cdot \underline{I}^{S}_{BF,m}$$

$\delta$

$$\underline{Zc}_m \cdot \cosh(\underline{\gamma}_m \cdot \frac{L}{2}) \cdot \underline{I}^{R,sync}_{BF,m}$$

$$\sinh(\underline{\gamma}_m \cdot \frac{L}{2}) \cdot \underline{V}^{S}_{BF,m}$$

$$\underline{\varepsilon}I_m$$

$$\sinh(\underline{\gamma}_m \cdot \frac{L}{2}) \cdot \underline{V}^{R,async}_{BF,m}$$

$$\sinh(\underline{\gamma}_m \cdot \frac{L}{2}) \cdot \underline{V}^{R,sync}_{BF,m}$$

FIG 4